# EUROPÄISCHE PATENTANMELDUNG

(11) **EP 2 690 935 A1**
(43) Veröffentlichungstag der Anmeldung: **29.01.2014**
(21) Anmeldenummer: 13177340.0
(22) Anmeldetag: 22.07.2013
(51) Int. Cl.: H05K 1/02, H05K 1/11

(54) **Leiterplatte zum Bestücken mit Leuchtkörpern**

(30) Priorität: 24.07.2012 DE 202012102767 U
(71) Anmelder: Zumtobel Lighting GmbH, 6850 Dornbirn (AT)
(72) Erfinder: Block, Steffen, 6923 Lauterach (AT)
(74) Vertreter: Thun, Clemens

(57) **Zusammenfassung**

Leiterplatte (11, 22) zum Bestücken mit Leuchtkörpern, insbesondere LEDs (15, 16), mit mindestens einem Bestückungsbereich (1/2, 2/2, 1/6-6/6), wobei der Bestückungsbereich (1/2, 2/2, 1/6-6/6) mindestens zwei Anschlussmöglichkeiten (2) für Leuchtkörper (15) aufweist, welche an voneinander getrennt ansteuerbare Kanäle (Ch1-Ch4) angeschlossen sind und wobei innerhalb des Bestückungsbereichs (1/2, 2/2, 1/6-6/6) einer der mindestens zwei Anschlussmöglichkeiten (2) eine zusätzliche Anschlussmöglichkeit (14) für einen Leuchtkörper (16) zugeordnet ist, wobei die Anschlussmöglichkeit (2) und die der Anschlussmöglichkeit (2) zugeordnete zusätzliche Anschlussmöglichkeit (14) an den gleichen Kanal (Ch3) angeschlossen sind.

## Beschreibung

Die vorliegende Erfindung betrifft eine Leiterplatte zum Bestücken mit Leuchtkörpern, insbesondere LEDs, mit mindestens einem Bestückungsbereich, wobei der Bestückungsbereich mindestens zwei Anschlussmöglichkeiten für Leuchtkörper aufweist, welche an voneinander getrennt ansteuerbare Kanäle angeschlossen sind.

Bei elektrischen bzw. elektronischen Geräten, bei denen mehrere LEDs Anwendung finden, kommen häufig Leiterplatten bzw. Platinen zum Einsatz, auf denen die LEDs gemeinsam angeordnet werden. Hierbei besteht das Problem, dass für jedes neue derartige Gerät bzw. jede neue Anwendung zumeist eine neue Leiterplatte entwickelt und hergestellt werden muss, da für verschiedene Geräte bzw. Anwendungen selten die gleiche Farbwiedergabe, Farbintensität und dergleichen bzw. das gleiche Muster und der gleiche Abstand benötigt wird und es eine Vielzahl unterschiedlicher LED-Typen gibt, die sich bspw. in ihren Bauformen und Anschlussmöglichkeiten unterscheiden.

Durch die jeweils erforderliche Neuentwicklung einer Leiterplatte, auf der mehrere LEDs angebracht werden können, ergibt sich eine Reihe von Nachteilen. Zum einen besteht die Problematik, dass erst während der Entwicklung eines neuen Geräts bzw. einer neuen Anwendung die genaue Positionierung der LEDs bekannt wird, wodurch erst dann mit der Entwicklung der entsprechenden Leiterplatte begonnen werden kann, wodurch sich entsprechend längere Lieferzeiten ergeben können. Zum anderen führen auch die unter Umständen geringen Stückzahlen und die jeweils neu erforderliche Entwicklung eines Layouts für die Leiterplatte zu höheren Kosten.

Um eine flexible Bestückung durch LEDs zu ermöglichen, sind dementsprechend bereits Leiterplatten bekannt, die mehrere voneinander getrennt ansteuerbare Kanäle aufweist, wobei an einem Kanal mehrere Anschlussmöglichkeiten, sogenannte Footprints, für LEDs vorgesehen sind. Hierbei weist dann die Leiterplatte mehrere Bestückungsbereiche, sogenannte LED-Cluster, auf, wobei in jedem Bestückungsbereich eine Anschlussmöglichkeit jedes Kanals angeordnet ist.

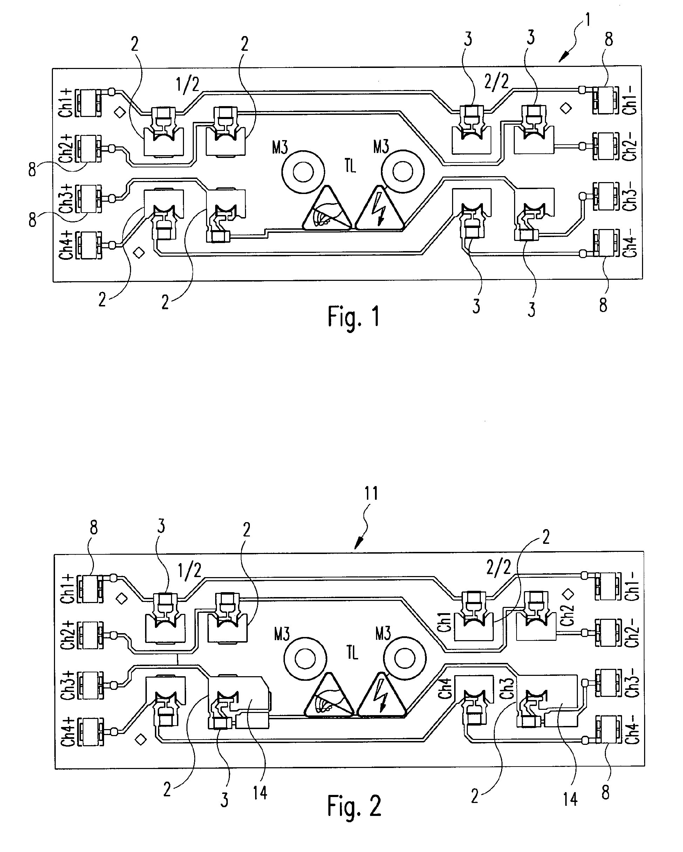

In Figur 1 ist beispielhaft eine derartige Leiterplatte 1 gezeigt, die vier Kanäle Ch1 bis Ch4 und zwei Bestückungsbereiche 1/2 und 2/2 aufweist. Wie der Figur 1 entnommen werden kann, ist dann vorgesehen, dass jeder Bestückungsbereich 1/2 bzw. 2/2 vier Anschlussmöglichkeiten 2 aufweist, wobei jede der vier Anschlussmöglichkeiten 2 innerhalb eines Bestückungsbereichs 1/2 bzw. 2/2 einem anderen Kanal Chl, Ch2, Ch3 bzw. Ch4 zugeordnet bzw. mit einem anderen Kanal Ch1, Ch2, Ch3 bzw. Ch4 verbunden ist. Bei der in Figur 1 gezeigten Leiterplatte 1 ist dabei vorgesehen, dass die beiden Bestückungsbereiche 1/2 und 2/2 in Längsrichtung der länglichen Leiterplatte 1 verteilt angeordnet sind, wobei die Anschlussmöglichkeiten 2 in beiden Bestückungsbereichen 1/2 und 2/2 in vergleichbarer Weise angeordnet sind. Zusätzlich sind die Anschlussmöglichkeiten 2 eines Kanals Chl, Ch2, Ch3 bzw. Ch4 in Reihe miteinander verbunden, d.h., dass bspw. die Anschlussmöglichkeit 2 des Kanals Ch1 des Bestückungsbereichs 1/2 mit der Anschlussmöglichkeit 2 des Kanals Ch1 des Bestückungsbereichs 2/2 in Serie verbunden ist.

An den Enden der Leiterplatte 1 sind dann zusätzlich noch Schneid-Klemm-Kontakte 8 zur Anbringung einer Verkabelung angeordnet, wobei für jeden Kanal Chl, Ch2, Ch3 bzw. Ch4 entsprechend ein eigener Schneid-Klemm-Kontakt 8 vorgesehen ist.

Durch die Ausgestaltung der Leiterplatte 1 in Figur 1 ergeben sich somit vier voneinander getrennt ansteuerbare Kanäle Ch1 bis Ch4, wobei innerhalb eines Kanals Chl, Ch2, Ch3 bzw. Ch4 die entsprechenden Positionen jeweils vorzugsweise von gleichartigen LEDs besetzt werden.

Bei der in Figur 1 gezeigten Leiterplatte 1 ist zumeist vorgesehen, dass entweder alle oder keine Anschlussmöglichkeiten 2 eines Kanals Chl, Ch2, Ch3 bzw. Ch4 mit LEDs bestückt wird. Allerdings kann es auch bei einigen Anwendungen bzw. Geräten erforderlich sein, dass nur ein Teil der Anschlussmöglichkeiten 2 eines Kanals Ch1, Ch2, Ch3 bzw. Ch4 mit LEDs bestückt wird. Da die Anschlussmöglichkeiten 2 eines Kanals Chl, Ch2, Ch3 bzw. Ch4 in Reihe angeordnet bzw. miteinander verbunden sind, ist es dann erforderlich, dass die nichtbestückten Anschlussmöglichkeiten 2 entsprechend überbrückt werden. Hierfür weisen dann die Anschlussmöglichkeiten 2 jeweils eine Anschlussmöglichkeit 3 für einen 0-Ohm-Widerstand auf, welche bei der in Figur 1 gezeigten Leiterplatte 1 jeweils unmittelbar benachbart zu den Anschlussmöglichkeiten 2 angeordnet sind.

Die in Figur 1 gezeigte Leiterplatte 1 kann nun beispielhaft derart bestückt werden, dass die Anschlussmöglichkeiten 2 des Kanals Ch1 rote LEDs, die Anschlussmöglichkeiten 2 des Kanals Ch2 grüne LEDs und die Anschlussmöglichkeiten 2 des Kanals Ch4 blaue LEDs aufweisen, wodurch die Leiterplatte 1 in einer sog. RGB-Variante bestückt ist. Zusätzlich kann dann aber auch noch vorgesehen sein, dass die Anschlussmöglichkeiten 2 des Kanals Ch3 weiße LEDs aufweisen und die Leiterplatte 1 somit in einer sog. RGBW-Variante bestückt ist.

Bei der in Figur 1 gezeigten Leiterplatte 1 ist es dann vorgesehen, dass alle Anschlussmöglichkeiten 2 mit demselben LED-Typ bzw. LEDs desselben Herstellers bestückt werden und somit sowohl für die roten, grünen und blauen als auch für die weißen LEDs derselbe Type bzw. dieselbe Bauform verwendet wird. So wäre es bspw. denkbar, dass die Anschlussmöglichkeiten 2 mit LEDs der Firma Phillips bestückt werden. Hierbei besteht dann aber das Problem, dass weiße LEDs der Firma Phillips nur mit einem Farbwiedergabewert bzw. CRI-Wert von 70 verfügbar sind. Ein höherer CRI-Wert für die Lichtabgabe, bspw. ein CRI-Wert von 80 bei 5500k ist somit bei der in Figur 1 gezeigten Leiterplatte 1 nicht möglich.

Aufgabe der vorliegenden Erfindung ist es somit, eine Leiterplatte zum Bestücken mit Leuchtkörpern zu entwickeln, die mehrere Kanäle aufweist und gleichzeitig eine Flexibilität bei der Lichtabgabe, bspw. des Farbwiedergabewerts, ermöglicht.

Die Aufgabe wird durch eine Leiterplatte zum Bestücken mit Leuchtkörpern gemäß dem Anspruch 1 gelöst. Vorteilhafte Weiterbildungen der Erfindung sind Gegenstand der abhängigen Ansprüche.

Erfindungsgemäß wird eine Leiterplatte zum Bestücken mit Leuchtkörpern, insbesondere LEDs, mit mindestens einem Bestückungsbereich vorgeschlagen, wobei der Bestückungsbereich mindestens zwei Anschlussmöglichkeiten für Leuchtkörper aufweist, welche an voneinander getrennt ansteuerbare Kanäle angeschlossen sind. Hierbei ist dann vorgesehen, dass innerhalb des Bestückungsbereichs einer der mindestens zwei Anschlussmöglichkeiten eine zusätzliche Anschlussmöglichkeit für einen Leuchtkörper zugeordnet ist, wobei die Anschlussmöglichkeit und die der Anschlussmöglichkeit zugeordnete zusätzliche Anschlussmöglichkeit an den gleichen Kanal angeschlossen sind.

Vorteilhafterweise kann dabei vorgesehen sein, dass die Anschlussmöglichkeit mit der zugeordneten zusätzlichen Anschlussmöglichkeit und die zusätzliche Anschlussmöglichkeit für Leuchtkörper mit unterschiedlicher Bauform oder unterschiedlicher Type vorgesehen sind.

Diese zusätzliche Anschlussmöglichkeit kann dann mit einer LED eines anderen Herstellers, bspw. Cree- oder Nichia-LEDs, bestückt werden. Somit ergibt sich dann bspw. für den Fall, dass die Anschlussmöglichkeit, welcher die zusätzliche Anschlussmöglichkeit zugeordnet ist, mit einer Phillips-LED mit einem CRI-Wert von 70 bei 6000k bestückt wird, die Möglichkeit, die zusätzliche Anschlussmöglichkeit bspw. mit einer Cree-LED mit einem CRI-Wert von 85 bei 4000k zu bestücken, wodurch dann ein gewünschter CRI-Wert von 80 bei 5500k erreicht werden kann.

Durch die erfindungsgemäße Ausgestaltung der Leiterplatte ist es somit möglich, zwei LEDs zu kombinieren, wodurch Eigenschaften erreicht werden können, die durch eine LED nicht möglich wären.

Hierbei kann vorgesehen sein, dass die zusätzliche Anschlussmöglichkeit unmittelbar benachbart zu der Anschlussmöglichkeit mit der zugeordneten zusätzlichen Anschlussmöglichkeit angeordnet ist.

Vorteilhafterweise kann die zusätzliche Anschlussmöglichkeit parallel zu der Anschlussmöglichkeit mit der zugeordneten zusätzlichen Anschlussmöglichkeit an den Kanal angeschlossen sein. Alternativ besteht aber auch die Möglichkeit, dass die zusätzliche Anschlussmöglichkeit in Reihe an den Kanal angeschlossen ist. Bei in Reihe angeschlossener zusätzlicher Anschlussmöglichkeit kann dann auch vorgesehen sein, dass der zusätzlichen Anschlussmöglichkeit innerhalb des Bestückungsbereichs eine weitere Anschlussmöglichkeit für eine Überbrückungseinheit, insbesondere eine 0-Ohm-Widerstand, innerhalb des Bestückungsbereichs zugeordnet ist.

Ebenso kann auch vorgesehen sein, dass den mindestens zwei Anschlussmöglichkeiten jeweils eine weitere Anschlussmöglichkeit für eine Überbrückungseinheit, insbesondere einen Null-Ohm-Widerstand, innerhalb des Bestückungsbereichs zugeordnet ist.

Vorzugsweise weist der Bestückungsbereich vier Anschlussmöglichkeiten für Leuchtkörper auf, welche jeweils an voneinander getrennt ansteuerbare Kanäle angeschlossen sind. Hierdurch ergeben sich dann vier voneinander getrennte Kanäle.

Des Weiteren kann vorteilhafterweise auch vorgesehen sein, dass die Leiterplatte mindestens zwei Bestückungsbereiche aufweist und jeweils ein Kanal eines Bestückungsbereichs mit einem Kanal eines benachbarten Bestückungsbereichs verbunden ist und einen gemeinsam Kanal bildet. Die Verbindung der Kanäle eines Bestückungsbereichs mit den Kanälen eines benachbarten Bestückungsbereichs kann hierbei jeweils in Reihe erfolgen. Zusätzlich kann auch vorgesehen sein, dass die Leiterplatte sechs Bestückungsbereiche aufweist.

Außerdem kann vorgesehen sein, dass die Leiterplatte an ihren Endbereichen Schneid-Klemm-Kontakte, Klemmkontakte und/oder Lötstellen zur Anbringung einer Verkabelung aufweist, die jeweils mit den Kanälen verbunden sind.

Die zuvor angeführten Leiterplatten können dann auch in einem Leuchtmodul angeordnet sein, wobei bspw. mindestens zwei entsprechende Leiterplatten vorgesehen sind, und jeweils ein Kanal einer Leiterplatte mit einem Kanal einer benachbarten Leiterplatte verbunden ist und einen gemeinsamen Kanal bildet.

Ebenso kann auch vorgesehen sein, dass mindestens eine Leiterplatte in einem Leuchtmodul angeordnet ist, wobei zumindest ein Teil der Kanäle der Leiterplatte jeweils miteinander verbunden ist. Diese Möglichkeit besteht auch bei der zuvor erwähnten Anordnung von mindestens zwei Leiterplatten in dem Leuchtmodul. Des Weiteren kann auch noch vorgesehen sein, dass alle Kanäle der Leiterplatte jeweils miteinander verbunden sind und einen gemeinsamen Kanal bilden.

Nachfolgend soll die Erfindung anhand von Ausführungsbeispielen und den beiliegenden Zeichnungen näher erläutert werden. Es zeigen:
- Figur 1: Leiterplatte zum Bestücken mit LEDs aus dem Stand der Technik;
- Figur 2: eine erfindungsgemäße Leiterplatte zum Bestücken mit LEDs entsprechend einer ersten Ausführungsform;
- Figur 3: die in Figur 2 gezeigte Leiterplatte vollständig mit LEDs und 0-Ohm-Widerständen bestückt;
- Figur 4: Schaltplan der in Figur 2 gezeigten Leiterplatte;
- Figur 5: eine erfindungsgemäße Leiterplatte zum Bestücken mit LEDs entsprechend einer zweiten Ausführungsform der vorliegenden Erfindung;
- Figur 6: die in Figur 5 gezeigte Leiterplatte vollständig mit LEDs und 0-Ohm-Widerständen bestückt.

In Figur 1 ist, wie bereits erläutert, eine aus dem Stand der Technik bekannte Leiterplatte 1 zum Bestücken mit LEDs gezeigt. Die Leiterplatte 1 weist dabei vier Kanäle Ch1 bis Ch4 auf, die voneinander getrennt ansteuerbar sind. Des Weiteren können der Leiterplatte 1 in Figur 1 auch zwei Bestückungsbereiche 1/2 und 2/2, sogenannte LED-Cluster, entnommen werden, die jeweils Anschlussmöglichkeiten 2, sogenannte Footprints, für LEDs aufweist. Hierbei ist im Einzelnen vorgesehen, dass in jedem Bestückungsbereich 1/2 bzw. 2/2 an jedem Kanal Chl, Ch2, Ch3 bzw. Ch4 jeweils eine Anschlussmöglichkeit 2 angeschlossen ist. D.h., dass bei der in Figur 1 gezeigten Leiterplatte 1 mit vier Kanälen Ch1 bis Ch4 in jedem Bestückungsbereich 1/2 bzw. 2/2 vier Anschlussmöglichkeiten 2 vorgesehen sind.

Des Weiteren ist dann vorgesehen, dass die Anschlussmöglichkeiten 2 eines Kanals Chl, Ch2, Ch3 bzw. Ch4 in unterschiedlichen Bestückungsbereichen in Reihe bzw. seriell miteinander verbunden sind. D.h., dass die Anschlussmöglichkeit 2 des Kanals Ch1 in dem Bestückungsbereich 1/2 auf der Leiterplatte 1 in Figur 1 seriell mit der Anschlussmöglichkeit 2 des Kanals Ch1 in dem Bestückungsbereich 2/2 verbunden ist.

Wie bereits zuvor erwähnt, kann dann vorgesehen sein, dass nur die Anschlussmöglichkeiten 2 der Kanäle Chl, Ch2 und Ch4 mit entsprechenden LEDs bestückt sind, bspw. mit roten LEDs in Kanal Chl, grünen LEDs in Kanal Ch2 und blauen LEDs in Kanal Ch4. Zusätzlich kann dann aber auch vorgesehen sein, dass die Anschlussmöglichkeiten 2 des Kanals Ch3 mit weißen LEDs bestückt sind. Wie der Leiterplatte 1 in Figur 1 zu entnehmen ist, ist dabei vorgesehen, dass alle Anschlussmöglichkeiten 2 derart ausgestaltet sind, dass sie mit LEDs des gleichen Type bzw. der gleichen Bauform bestückt werden können. Denkbar wäre es in diesem Fall dann bspw., dass LEDs der Firma Phillips eingesetzt werden. In diesem Fall besteht dann aber das Problem, dass, wie bereits oben erläutert, hier nur LEDs bis zu einem CRI-Wert von 70 verfügbar sind.

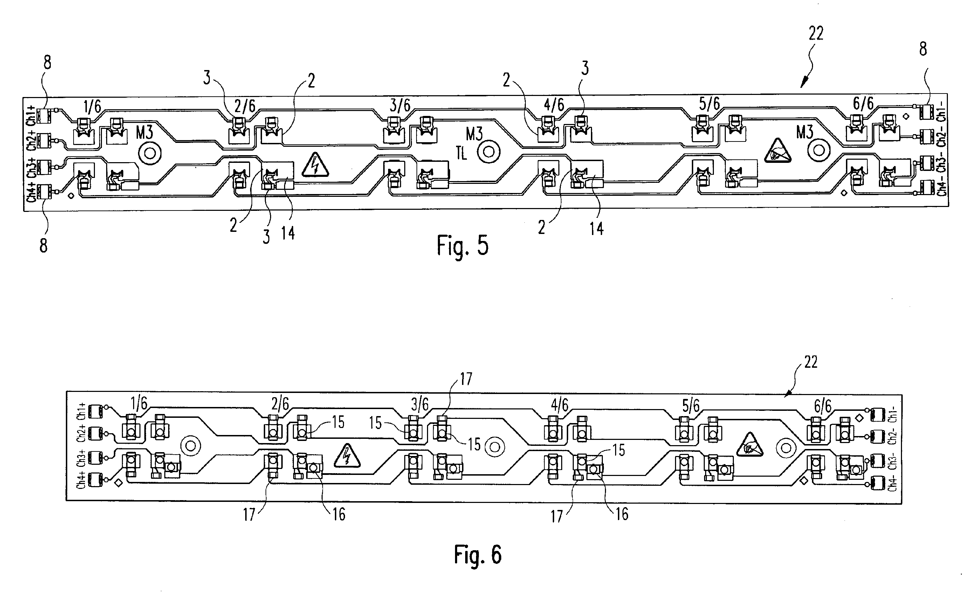

Für den Fall, dass dann jedoch ein höherer CRI-Wert gewünscht ist, bspw. ein CRI-Wert von 80 bei 5500k, ist dies nicht so ohne Weiteres in der in Figur 1 gezeigten Leiterplatte 1 möglich. Erfindungsgemäß ist hierfür dann nunmehr die in Figur 2 gezeigte Leiterplatte 11 bzw. die in Figur 5 gezeigte Leiterplatte 22 vorgesehen.

Die in Figur 2 dargestellte Leiterplatte 11 zeigt eine erste Ausführungsform der vorliegenden Erfindung und entspricht größtenteils der in Figur 1 gezeigten Leiterplatte 1. Der einzige Unterschied zwischen den Leiterplatten 1 und 11 besteht darin, dass in einem der Kanäle Chl, Ch2, Ch3 bzw. Ch4 die Anschlussmöglichkeiten 2 jeweils eine zusätzliche Anschlussmöglichkeit 14 aufweisen, die zur Bestückung mit einer weiteren LED ausgelegt ist. Hierbei ist vorgesehen, dass die zusätzliche Anschlussmöglichkeit 14 unmittelbar benachbart zur entsprechenden Anschlussmöglichkeit 2 angeordnet ist.

Bei der Leiterplatte 11 in Figur 2 sind diese zusätzlichen Anschlussmöglichkeiten 14 den Anschlussmöglichkeiten 2 des Kanals Ch3 zugeordnet. D.h., dass jede Anschlussmöglichkeit 2 des Kanals Ch3 um eine zusätzliche Anschlussmöglichkeit 14 erweitert ist, wobei diese zusätzliche Anschlussmöglichkeit 14 direkt an der Anschlussmöglichkeit 2 angeordnet ist. Die zusätzliche Anschlussmöglichkeit 14 ist hierbei derart ausgestaltet, dass diese mit LEDs bestückt werden kann, die sich im Type oder in der Bauform von den LEDs unterscheiden mit denen die Anschlussmöglichkeit 2 bestückt werden kann.

Durch diese Ausgestaltung wird es dann bspw. möglich, dass die Anschlussmöglichkeit 14 mit einer Cree-LED bestückt wird, die einen CRI-Wert von 85 bei 4000k aufweist. In Kombination mit der Phillips-LED mit einem CRI-Wert von 70 bei 6000k ergibt sich dann der gewünschte CRI-Wert von 80 bei 5500k.

Somit ergibt sich dann, durch die besondere Ausgestaltung, dass den Anschlussmöglichkeiten 2 eines Kanals Chl, Ch2, Ch3 bzw. Ch4 zusätzliche Anschlussmöglichkeiten 14 zugeordnet werden, die Möglichkeit, bestimmte Eigenschaften durch die Kombination von LEDs unterschiedlicher Hersteller zu erreichen, die mit einer LED eines Herstellers nicht erreicht werden können.

Bei der in Figur 2 gezeigten Leiterplatte 11 ist es im Einzelnen vorgesehen, dass die zusätzliche Anschlussmöglichkeit 14 parallel zu der Anschlussmöglichkeit 2 des Kanals Ch3 angeschlossen ist, wodurch die Leiterplatte 11 nach wie vor auch ohne Weiteres ohne Bestückung der zusätzlichen Anschlussmöglichkeiten 14 vergleichbar mit der Leiterplatte 1 in Figur 1 verwendet werden kann.

Bei dieser parallelen Anordnung der Anschlussmöglichkeiten 14 ist dann allerdings zu beachten, dass sowohl die LEDs für die Anschlussmöglichkeiten 2 als auch die LEDs für die Anschlussmöglichkeiten 14 jeweils mit der gleichen Spannung betrieben werden können müssen.

Des Weiteren ist zu der erfindungsgemäßen Leiterplatte 11 in Figur 2 auch noch anzumerken, dass diese ähnlich wie die Leiterplatte 1 in Figur 1 Anschlussmöglichkeiten 3 für 0-Ohm-Widerstände aufweist. Im Einzelnen ist hierbei jeder Anschlussmöglichkeit 2 eine derartige Anschlussmöglichkeit 3 für einen 0-Ohm-Widerstand zugeordnet, die es ermöglicht, die jeweilige Anschlussmöglichkeit 2 bei Nichtbenutzung entsprechend zu überbrücken, wodurch es möglich ist, dass innerhalb eines Kanals Chl, Ch2, Ch3 bzw. Ch4 nicht alle Anschlussmöglichkeiten 2 bestückt werden müssen. Wie aus Figur 2 hervorgeht, ist eine derartige Anschlussmöglichkeit 3 für einen 0-Ohm-Widerstand auch den Anschlussmöglichkeiten 2 des Kanals Ch3 zugeordnet, wobei diese Anschlussmöglichkeit 3 für einen 0-Ohm-Widerstand insbesondere dann notwendig wird, wenn sowohl die Anschlussmöglichkeit 2 als auch die zusätzliche Anschlussmöglichkeit 14 nicht mit einer LED bestückt wird. Hieraus ergibt sich dann auch, dass es möglich wäre nur die zusätzliche Anschlussmöglichkeit 14 nicht aber die entsprechende Anschlussmöglichkeit 2 mit einer LED zu bestücken, wobei in diesem Fall keine entsprechende Überbrückung erforderlich ist.

Alternativ könnten die zusätzlichen Anschlussmöglichkeiten 14 aber jeweils auch in Reihe zu den entsprechenden Anschlussmöglichkeiten 2 angeordnet sein. In diesem Fall wäre es allerdings erforderlich, dass eine weitere Anschlussmöglichkeit für einen 0-Ohm-Widerstand vorgesehen ist, die für den Fall, dass die zusätzliche Anschlussmöglichkeit 14 nicht mit einer LED bestückt ist, diese entsprechend überbrücken kann.

Wie auch die in Figur 1 gezeigte Leiterplatte 1 weist auch die in Figur 2 gezeigte Leiterplatte 11 an ihren Endbereichen Schneid-Klemm-Kontakte 8 auf, die zur Anbringung einer Verkabelung vorgesehen sind, wobei jeder Schneid-Klemm-Kontakt 8 mit einem der Kanäle Chl, Ch2, Ch3 bzw. Ch4 verbunden ist.

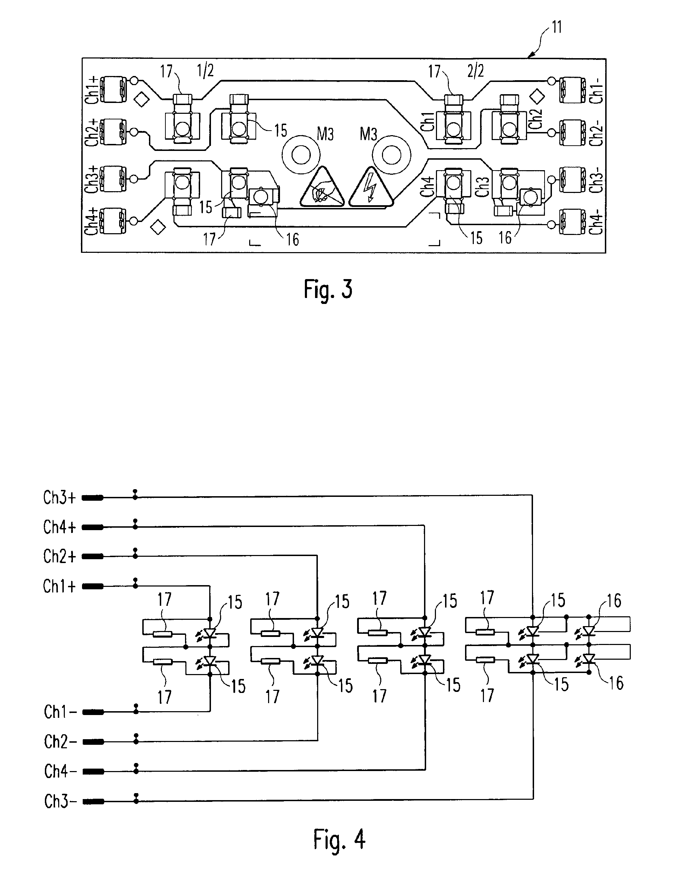

In Figur 3 ist die in Figur 2 gezeigte Leiterplatte 11 vollständig mit entsprechenden LEDs 15 und 16 bestückt. Der Figur 3 kann dabei entnommen werden, dass die Anschlussmöglichkeiten 2 und 14 mit jeweils anderen LEDs 15 und 16 bestückt sind. Wie bereits erläutert, kann es sich bspw. bei den LEDs 15 der Anschlussmöglichkeiten 2 um Phillips-LEDs handeln und bei den LEDs 16 der Anschlussmöglichkeiten 14 um entsprechende Cree-LEDs. Die Bestückung der Leiterplatte 11 in Figur 3 ist allerdings lediglich als Beispiel anzusehen. Ebenso ist es auch denkbar, dass einige der Kanäle Chl, Ch2, Ch3 bzw. Ch4 überhaupt nicht oder nur zum Teil bestückt werden.

Zusätzlich sind bei der in Figur 3 gezeigten Leiterplatte 11 auch die Anschlussmöglichkeiten 3 mit 0-Ohm-Widerständen 17 bestückt. Dies dient hier allerdings lediglich dazu, aufzuzeigen, wie eine entsprechende Bestückung erfolgt. Wenn eine derartige Leiterplatte 11 dann jedoch eingesetzt werden soll, ist es selbstverständlich erforderlich, dass jeweils entweder nur die LEDs 15 und 16 oder die 0-Ohm-Widerstände 17 vorgesehen sind.

Zu den Anschlussmöglichkeiten 3 für die 0-Ohm-Widerstände 17 ist des Weiteren auch noch anzumerken, dass diese unmittelbar benachbart zu den entsprechenden Anschlussmöglichkeiten 2 angeordnet sind.

Figur 4 zeigt dann einen Schaltungsplan der in Figur 3 gezeigten Leiterplatte 11, wobei auch hier wiederum sowohl die 0-Ohm-Widerstände 17 als auch die LEDs 15 und 16 dargestellt sind. Zusätzlich kann dem Schaltplan in Figur 4 auch entnommen werden, dass in Kanal Ch3 zu den LEDs 15, parallel zusätzliche LEDs 16 angeordnet sind.

In den Figuren 5 und 6 ist dann eine weitere Ausführungsform der vorliegenden Erfindung gezeigt. Diesen Figuren kann eine Leiterplatte 22 entnommen werden, die wiederum ebenfalls vier Kanäle Ch1 bis Ch4 aufweist. Zusätzlich können der Leiterplatte 22 auch mehrere Bestückungsbereiche 1/6 bis 6/6 entnommen werden, wobei jeder dieser Bestückungsbereiche vergleichbar mit den Bestückungsbereichen 1/2 und 2/2 der Leiterplatte 11 in Figur 2 bzw. 3 aufgebaut ist. D.h., dass jeder Bestückungsbereich 1/6, 2/6, 3/6, 4/6, 5/6 bzw. 6/6 der Leiterplatte 22 vier Anschlussmöglichkeiten 2 aufweist und die Anschlussmöglichkeiten 2 des Kanals Ch3 die zusätzlichen Anschlussmöglichkeiten 14.

Gegenüber der Leiterplatte 11 in den Figuren 2 und 3 weist die Leiterplatte 22 in den Figuren 5 und 6 nunmehr jedoch sechs Bestückungsbereiche 1/6 bis 6/6 auf, wobei zu beachten ist, dass die jeweils benachbarten Bestückungsbereiche 1/6, 2/6, 3/6, 4/6, 5/6 bzw. 6/6 in Reihe miteinander verbunden sind. D.h., dass bspw. die Anschlussmöglichkeit 2 des Kanals Ch1 des Bestückungsbereichs 1/6 mit der Anschlussmöglichkeit 2 des Kanals Ch1 des Bestückungsbereichs 2/6 verbunden ist und diese dann wiederum mit der Anschlussmöglichkeit 2 des Kanals Ch1 des Bestückungsbereichs 3/6 usw.. Hierdurch sind dann alle Anschlussmöglichkeiten 2 des Kanals Ch1 in Reihe bzw. Serie geschaltet.

In Figur 5 ist dann die Leiterplatte 22 wiederum, wie auch die Leiterplatte 11 in Figur 2, ohne entsprechende LEDs und 0-Ohm-Widerstände gezeigt. Demgegenüber sind bei der Leiterplatte 22 in Figur 6, ebenso wie bei der Leiterplatte 11 in Figur 3, alle Anschlussmöglichkeiten 2 und 14 mit LEDs 15 und 16 und die Anschlussmöglichkeiten 3 mit 0-Ohm-Widerständen 17 bestückt.

Die in den Figuren 2 und 3 gezeigte Leiterplatte 11 und die in den Figuren 5 und gezeigte Leiterplatte 22 weisen sowohl eine unterschiedliche Länge als auch eine unterschiedliche Anzahl von Bestückungsbereichen auf. Neben diesen beiden Leiterplatten 11 und 22 sind aber auch Leiterplatten beliebig anderer Länge und mit einer beliebigen Anzahl von Bestückungsbereichen vorstellbar. Somit ist es dann möglich, dass für eine nahezu beliebige Gesamtlänge eine kontinuierliche Lichtabgabe durch entsprechendes Kombinieren verschiedener Leiterplatten erreicht werden kann.

Des Weiteren ist auch noch ein Leuchtmodul vorgesehen, das mehrere der oben beschriebenen Leiterplatten 11 bzw. 22 aufweist, die miteinander verbunden sind, wobei jeweils ein Kanal Chl, Ch2, Ch3 bzw. Ch4 einer Leiterplatte 11 bzw. 22 mit einem Kanal Chl, Ch2, Ch3 bzw. Ch4 einer benachbarten Leiterplatte 11 bzw. 22 verbunden ist und somit einen gemeinsamen Kanal bildet. Die Verbindung erfolgt hierbei über die Scheid-Klemm-Kontakte 8. Hierbei ist es dann, wie bereits zuvor erwähnt möglich, dass bspw. eine Leiterplatte 11 entsprechend den Figuren 2 und 3 und eine Leiterplatte 22 entsprechend den Figuren 5 und 6 zusammen verwendet wird.

Des Weiteren ist auch ein Leuchtmodul vorgesehen, das mindestens eine Leiterplatte 11 bzw. 22 aufweist, wobei zumindest ein Teil der Kanäle Chl, Ch2, Ch3 bzw. Ch4 in der Leiterplatte 11 bzw. 22 jeweils miteinander verbunden ist. D.h., dass die Kanäle Ch1 bis Ch4 so untereinander geschaltet werden, dass sich eine längere serielle Verschaltung von LEDs ergibt, die sich dann bspw. über zwei oder sogar mehr Kanäle Ch1, Ch2, Ch3 bzw. Ch4 hinweg erstreckt.

Bei der in den Figuren 2 und 3 gezeigten Leiterplatte 11 wäre es bspw. möglich, dass die Kanäle Chl, Ch2 und Ch3 zu einem gemeinsamen Kanal verbunden sind und somit die Leiterplatte 11 dann lediglich noch zwei Kanäle aufweist, nämlich den gemeinsamen Kanal bestehend aus den Kanälen Ch1 bis Ch3 und den separaten Kanal Ch4.

Ebenso wäre es aber auch denkbar, dass alle Kanäle Ch1 bis Ch4 miteinander verbunden werden, wodurch dann insgesamt ein gemeinsamer Kanal entsteht.

Zusätzlich kann dabei auch vorgesehen sein, dass mehrere Leiterplatten 11 bzw. 22 innerhalb des Leuchtmoduls angeordnet sind, wobei ein Teil der Kanäle Chl, Ch2, Ch3 bzw. Ch4 mit dem benachbarten Leiterplatten 11 bzw. 22 verbunden wird und ein anderer Teil der Kanäle Chl, Ch2, Ch3 bzw. Ch4 untereinander, um einen entsprechenden langen gemeinsamen Kanal zu bilden.

## Patentansprüche

1. Leiterplatte (11, 22) zum Bestücken mit Leuchtkörpern, insbesondere LEDs (15, 16), mit mindestens einem Bestückungsbereich (1/2, 2/2, 1/6-6/6), wobei der Bestückungsbereich (1/2, 2/2, 1/6-6/6) mindestens zwei Anschlussmöglichkeiten (2) für Leuchtkörper (15) aufweist, welche an voneinander getrennt ansteuerbare Kanäle (Ch1-Ch4) angeschlossen sind,
**dadurch gekennzeichnet,**
**dass** innerhalb des Bestückungsbereichs (1/2, 2/2, 1/6-6/6) einer der mindestens zwei Anschlussmöglichkeiten (2) eine zusätzliche Anschlussmöglichkeit (14) für einen Leuchtkörper (16) zugeordnet ist, wobei die Anschlussmöglichkeit (2) und die der Anschlussmöglichkeit (2) zugeordnete zusätzliche Anschlussmöglichkeit (14) an den gleichen Kanal (Ch3) angeschlossen sind.

2. Leiterplatte nach Anspruch 1,
**dadurch gekennzeichnet,**
**dass** die Anschlussmöglichkeit (2) mit der zugeordneten zusätzlichen Anschlussmöglichkeit (14) und die zusätzliche Anschlussmöglichkeit (14) für Leuchtkörper (15, 16) mit unterschiedlicher Bauform oder unterschiedlicher Type vorgesehen sind.

3. Leiterplatte nach einem der vorherigen Ansprüche,
**dadurch gekennzeichnet,**
**dass** die zusätzliche Anschlussmöglichkeit (14) unmittelbar benachbart zu der Anschlussmöglichkeit (2) mit der zugeordneten zusätzlichen Anschlussmöglichkeit (14) angeordnet ist.

4. Leiterplatte nach einem der vorherigen Ansprüche,
**dadurch gekennzeichnet,**
**dass** die zusätzliche Anschlussmöglichkeit (14) parallel zu der Anschlussmöglichkeit (2) mit der zugeordneten zusätzlichen Anschlussmöglichkeit (14) an den Kanal (Ch3) angeschlossen ist.

5. Leiterplatte nach einem der Ansprüche 1-3,
**dadurch gekennzeichnet,**
**dass** die zusätzliche Anschlussmöglichkeit (14) in Reihe zu der Anschlussmöglichkeit (2) mit der zugeordneten zusätzlichen Anschlussmöglichkeit (14) an den Kanal (Ch3) angeschlossen ist.

6. Leiterplatte nach Anspruch 5,
**dadurch gekennzeichnet,**
**dass** innerhalb des Bestückungsbereichs (1/2, 2/2, 1/6-6/6) der zusätzlichen Anschlussmöglichkeit (14) eine weitere Anschlussmöglichkeit für eine Überbrückungseinheit, insbesondere einen 0-Ohm Widerstand, zugeordnet ist.

7. Leiterplatte nach einem der vorherigen Ansprüche,
**dadurch gekennzeichnet,**
**dass** innerhalb des Bestückungsbereichs (1/2, 2/2, 1/6-6/6) den mindestens zwei Anschlussmöglichkeiten (2) jeweils eine weitere Anschlussmöglichkeit (3) für eine Überbrückungseinheit, insbesondere einen 0-Ohm Widerstand (17), zugeordnet ist.

8. Leiterplatte nach einem der vorherigen Ansprüche,
**dadurch gekennzeichnet,**
**dass** der Bestückungsbereich (1/2, 2/2, 1/6-6/6) vier Anschlussmöglichkeiten (2) für Leuchtkörper (15) aufweist, welche jeweils an voneinander getrennt ansteuerbare Kanäle (Ch1-Ch4) angeschlossen sind.

9. Leiterplatte nach einem der vorherigen Ansprüche,
**dadurch gekennzeichnet,**
**dass** die Leiterplatte (11, 22) mindestens zwei Bestückungsbereiche (1/2, 2/2, 1/6-6/6) aufweist und jeweils ein Kanal (Ch1-Ch4) eines Bestückungsbereichs (1/2, 2/2, 1/6-6/6) mit einem Kanal (Ch1-Ch4) eines benachbarten Bestückungsbereichs verbunden ist und einen gemeinsamen Kanal bildet.

10. Leiterplatte nach Anspruch 9,
**dadurch gekennzeichnet,**
**dass** die Verbindung der Kanäle (Ch1-Ch4) eines Bestückungsbereichs (1/2, 2/2, 1/6-6/6) mit den Kanälen (Ch1-Ch4) eines benachbarten Bestückungsbereichs (1/2, 2/2, 1/6-6/6) jeweils in Reihe erfolgt.

11. Leiterplatte nach einem der Ansprüche 9-10,
**dadurch gekennzeichnet,**
**dass** die Leiterplatte (22) sechs Bestückungsbereiche (1/6-6/6) aufweist.

12. Leiterplatte nach einem der vorherigen Ansprüche,
**dadurch gekennzeichnet,**
**dass** die Leiterplatte (11, 22) an ihren Endbereichen Schneid-Klemm-Kontakte (8), Klemmkontakte und/oder Lötstellen zur Anbringung einer Verkabelung aufweist, die jeweils mit den Kanälen (Ch1-Ch4) verbunden sind.

13. Leuchtmodul mit mindestens zwei Leiterplatten (11, 22) nach einem der vorherigen Ansprüche, wobei jeweils ein Kanal (Ch1-Ch4) einer Leiterplatte (11, 22) mit einem Kanal (Ch1-Ch4) einer benachbarten Leiterplatte (11, 22) verbunden ist und einen gemeinsamen Kanal bildet.

14. Leuchtmodul mit mindestens einer Leiterplatte (11, 22) nach einem der Ansprüche 1-12 oder Leuchtmodul nach Anspruch 13, wobei zumindest ein Teil der Kanäle (Ch1-Ch4) der Leiterplatte (11, 22) jeweils miteinander verbunden ist.

15. Leuchtmodul nach Anspruch 14, wobei alle Kanäle (Ch1-Ch4) der Leiterplatte (11, 22) jeweils miteinander verbunden sind und einen gemeinsamen Kanal bilden.
